(19) Europäisches Patentamt / European Patent Office / Office européen des brevets

(11) **EP 4 268 370 B1**

(12) **EUROPEAN PATENT SPECIFICATION**

(45) Date of publication and mention
of the grant of the patent:
**26.03.2025 Bulletin 2025/13**

(21) Application number: **21847499.7**

(22) Date of filing: **23.12.2021**

(51) International Patent Classification (IPC):
*H03K 5/19* (2006.01)      *B60B 23/04* (2006.01)

(52) Cooperative Patent Classification (CPC):
**B60B 23/04; H03K 5/19**

(86) International application number:
**PCT/EP2021/087624**

(87) International publication number:
**WO 2022/136695 (30.06.2022 Gazette 2022/26)**

(54) **DETECTION OF PULSE PATTERNS**

DETEKTION VON PULSMUSTERN

DÉTECTION DE DIAGRAMMES D'IMPULSIONS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **24.12.2020 NL 2027232**

(43) Date of publication of application:
**01.11.2023 Bulletin 2023/44**

(73) Proprietor: **Q*Bird B.V.**
**2628 CJ Delft (NL)**

(72) Inventor: **VERMEULEN, Raymond Frans Laurens**
**2600 AA Delft (NL)**

(74) Representative: **De Vries & Metman**
**Overschiestraat 180**
**1062 XK Amsterdam (NL)**

(56) References cited:
**US-B1- 10 725 361**

• **BOSO GIANLUCA ET AL: "High-throughput gated photon counter with two detection windows programmable down to 70 ps width", REVIEW OF SCIENTIFIC INSTRUMENTS, AMERICAN INSTITUTE OF PHYSICS, 2 HUNTINGTON QUADRANGLE, MELVILLE, NY 11747, vol. 85, no. 1, 21 January 2014 (2014-01-21), XP012180866, ISSN: 0034-6748, [retrieved on 19010101], DOI: 10.1063/1.4862060**

• **SHIGEYUKI MIYAJIMA ET AL: "Timing discriminator based on single-flux-quantum circuit toward high time-resolved photon detection", SUPERCONDUCTOR SCIENCE AND TECHNOLOGY, IOP PUBLISHING, TECHNO HOUSE, BRISTOL, GB, vol. 30, no. 12, 31 October 2017 (2017-10-31), XP020321857, ISSN: 0953-2048, [retrieved on 20171031], DOI: 10.1088/1361-6668/AA926E**

• **CRISTIANO NICLASS ET AL: "A 100-m Range 10-Frame/s 340 $\,\times\,$ 96-Pixel Time-of-Flight Depth Sensor in 0.18- $\mu\hbox{m}$ CMOS", IEEE JOURNAL OF SOLID-STATE CIRCUITS, IEEE, USA, vol. 48, no. 2, 24 January 2013 (2013-01-24), pages 559 - 572, XP011489698, ISSN: 0018-9200, DOI: 10.1109/JSSC.2012.2227607**

## Description

Technical field

The invention relates to detection of pulse patterns, and, in particular, though not exclusively, to methods and systems for pulse pattern detection, a quantum measurement apparatus, such as a Bell state measurement apparatus, comprising such pulse pattern detector and a computer program product for executing such methods.

Background

Quantum information systems are data processing systems that use a quantum system, e.g. a qubit, as an information carrier rather than classical bits '0' and '1' as used by conventional data processing system. Qubits can be represented as superposition of two orthogonal quantum states $|0\rangle$ and $|1\rangle$: $|\psi\rangle = \alpha|0\rangle + \beta|1\rangle$ wherein $\alpha$ and $\beta$ are complex amplitudes and $|\alpha|^2$ and $|\beta|^2$ are the probabilities to find the qubit in the $|0\rangle$ and $|1\rangle$ respectively. An example of a quantum information system is a so-called quantum key distribution (QKD) system, which allows two or more users at different locations to securely generate cryptographic keys based on the laws of quantum mechanics.

Optical quantum communication systems and quantum computing systems rely on quantum measurement stations, which may comprise a set of photon detectors configured to measure and detect optical pulses. For example, in the domain of quantum communication, quantum repeater networks and MDI-QKD systems require receiver stations which are configured to measure so-called Bell state measurements (BSMs). Such receiver stations may be configured to simultaneously register detector signals of a particular subset of detectors and checking that the specific detector timing response of that set (referred to as a detection pattern) corresponds to a Bell state measurement. In general, numerous sub-sets of detectors need to be registered and checked simultaneously. In order to facilitate high throughput communication or computation, the measurement station must operate at high frequencies, e.g. 200 MHz or more. In that case, information regarding quantum measurements of pulses has to be communicated at a rate of $10^8$ per second. To avoid the need of large storage systems, devices that process detector responses should be able to operate in real time.

Furthermore, the logical operation required from the measurement station to check for specific detection patterns may depend on the specific quantum measurement or quantum communication protocol or quantum computing algorithm (e.g. Bell state measurements, or other large entangled state projective measurements, etc.). Thus, devices that are configured to process detector responses would ideally have the flexibility to be quickly reprogrammed to check for different detection patterns, and should easily scale to many quantum computing system within the set. Furthermore, in order to bring quantum communication and quantum computing systems to market a solution satisfying the above requirements should also be as cheap and small as possible.

Known devices that can detect detection patterns and perform detection pattern analysis are either entirely analogue or entirely digital. The former devices are difficult to scale to large sets of detectors and cannot be readily reprogrammed for various detection patterns. The latter typically are FPGA-based time taggers and time-to-digital converters which may need a substantial amount of resources on the FGPA lattice, generate large amounts of superfluous data and can be quite expensive. An example of such a dedicated FPGA-based time-to-digital converter (TDC) is described in the article by, Arabul et al. A precise high count rate FPGA based multi-channel coincidence counting system for quantum photonic applications, IEEE Photonics Journal, Vol. 12, No. 2, April 2020. Boso Gianluca et al: "High-throughput gated photon counter with two detection windows programmable down to 70 ps width", REVIEW OF SCIENTIFIC INSTRUMENTS, vol. 85, no. 1, 21 January 2014, describes a high-throughput gated photo-counter able to count electrical pulses occuring within two well-defined and programmable detection windows.

Hence, from the above it follows there is a need in the art for improved pulse pattern detection. In particular, there is a need for methods and system for high-frequency, real-time pulse pattern detection that provide a scalable and low-cost solution to determine a particular detection pattern associated with a particular measurement setup that can be readily processed by a subsequent pattern analyzer.

Summary

As will be appreciated by one skilled in the art, aspects of the present invention may be embodied as a system, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Functions described in this disclosure may be implemented as an algorithm executed by a microprocessor of a computer. Furthermore, aspects of the present invention may take the form of a computer program product embodied in one or more computer readable medium(s) having computer readable program code embodied, e.g., stored, thereon.

The methods, systems, modules, functions and/or algorithms described with reference to the embodiments in this application may be realized in hardware, software, or a combination of hardware and software. The methods, systems, modules, functions and/or algorithms may be realized in a centralized fashion in at least one computing system, or in a distributed fashion where different elements are spread across several interconnected computing systems. Any kind of computing system or other apparatus adapted for carrying out the embodiments (or parts thereof) described in this application is suited. A typical implementation may comprise one or more digital circuits such as application specific integrated circuits (ASICs), one or more field programmable gate arrays (FPGAs), and/or one or more processors (e.g., x86, x64, ARM, PIC, and/or any other suitable processor architecture) and associated supporting circuitry (e.g., storage, DRAM, FLASH, bus interface circuits, etc.). Each discrete ASIC, FPGA, processor, or other circuit may be referred to as "chip," and multiple such circuits may be referred to as a "chipset." In an implementation, the programmable logic devices may be provided with fast RAM, in particular block RAM (BRAM). Another implementation may comprise a non-transitory machine-readable (e.g., computer readable) medium (e.g., FLASH drive, optical disk, magnetic storage disk, or the like) having stored thereon one or more lines of code that, when executed by a machine, cause the machine to perform processes as described in this disclosure.

The flowcharts and block diagrams in the figures may represent architecture, functionality, and operation of possible implementations of the methods, systems and/or modules to various embodiments of the present invention. In this regard, each block in a flowchart or a block diagrams may represent a module, segment, or portion of code, which be implemented as software, hardware or a combination of software and hardware.

It should also be noted that, in some alternative implementations, the functions noted in the blocks may occur out of the order noted in the figures. For example, two blocks shown in succession may, in fact, be executed substantially concurrently, or the blocks may sometimes be executed in the reverse order, depending upon the functionality involved. It will also be noted that each block of the block diagrams and/or flowchart illustrations, and combinations of blocks in the block diagrams and/or flowchart illustrations, can be implemented by special purpose hardware-based systems that perform the specified functions or acts, or combinations of special purpose hardware and computer instructions.

In a first aspect, the invention relates to a method of determining a detector pattern signal. The method comprises: receiving a base clock signal and an analog detector signal at a clock cycle of a clock signal, the analog detector signal being generated by a photon detection system, wherein the analog detector signal comprises one or more detector pulses of a predetermined pulse width at one or more temporal positions respectively, each detector pulse representing an optical pulse detected by the photon detection system, the one or more temporal positions being defined relative to the rising edge of the base clock signal; generating a first clock signal based on the base clock signal, the generating of the first clock signal including applying a first phase shift to the base clock signal so that the rising edge of first clock signal is at a first temporal position relative to the rising edge of the base clock signal; generating a first pulse signal based on the analog detector signal, the first pulse signal having a first pulse width that is smaller than the pulse width of the one or more detector pulses, the first pulse width being selected between 10 and 200 ps; the generating of the first pulse signal including: forming a first delayed detector signal by applying a first delay to the analog detector signal; forming a second delayed detector signal by applying a second delay to the analog detector signal and, determining the first pulse signal based on the first and second delayed detector signal; and, generating a digital detector pattern signal, the generating including determining a first digital signal based on the first pulse signal and the first clock signal, the first digital signal indicating whether the analog detector signal comprises a first detection pulse at the first temporal position as indicated by the rising edge of the first clock signal.

Hence, the invention relates to a method of determining a pulse detection pattern signal associated with an analog detector signal that may comprise different pulses representing different time bins in an optical signal that is detected by a detector. These pulses need to be detected and the pulse pattern formed by the pulses need to be analyzed, typically in real-time.

To determine a temporal position of the rising edge of a pulse in the analog pulse signal with respect to the clock, a clock signal may be copied into one or more phase shifted clock signals. Each individual clock signal may be phase-shifted to target a different temporal bin in the analog pulse signal (separated by at most 2 ns). Further, the width of one or more pulses in the analog pulse signal may be reduced to narrower pulses (e.g. down to 100 ps). Subsequently such narrow pulses may be fed to a d-flipflop which is clocked by one of the phase-shifted clock signals, thus achieving time-filtering, i.e. filtering in the time domain. If the analog pulse signal comprises a time bin at the temporal position, a digital signal may be generated indicating that a time bin at a certain temporal position has been detected.

The invention is scalable as the number of pulse pattern detectors can be stacked while providing input for the FPGA pattern analyzer. The pulse pattern detector may act as a time-filtering system as it only propagates digital pulses at its output, if analog pulses occur at its input within one of the temporal windows defined by the clock and d-flipflops. The pulse pattern analyzer may be programmed to search for any particular detection pattern so that can be used in a pulse counter system, a time-sensitive coincidence counter system, bell-state measurement system, a system configured to perform large entangled state projective measurements, etc.

In an embodiment, the first pulse signal may be determined by logically combining the analog detector signal and an inverted version of the analog detector signal.

In an embodiment, the rising edge of the first pulse signal may be determined by the rising edge of the analog detection signal and the falling edge of the first pulse signal may be determined inverted analog detection signal.

In an embodiment, the first digital signal may be generated by a first logic block configured to receive the first pulse signal and the first clock signal as input and to generate the first digital signal as output, preferably the first logic block including a first D flipflop clocked by the first clock signal.

In an embodiment, the method may further comprise: generating a second clock signal based on the base clock signal, the determining including copying the base clock signal and applying a second phase shift to the copied base clock signal so that the rising edge of second adjusted clock signal is at a second temporal position relative to the rising edge of the base clock signal; generating a second pulse signal based on the analog detector signal, the second pulse signal having a pulse width that is substantially smaller than the pulse width of the one or more detector pulses; and, generating a digital detector pattern signal, the determining further including: determining a second digital signal based on the second pulse signal and the second clock signal, the second digital signal being indicative whether the analog detection signal comprises a second detection pulse at the second temporal position.

In an embodiment, the second digital signal may be generated by a second logic block configured to receive the second pulse signal and the second clock signal as input and to generate the second digital signal as output, preferably the second logic block including a second D flipflop clocked by the second clock signal.

In an embodiment, the phase of the first digital signal and the phase of the second digital signal may be realigned.

By following up with a second d-flipflop that is clocked with the same clock signal in both channels the resulting digital pulses may be easily interfaced with an FPGA-based pattern analysis system that may be clocked based on the same clock signal as the pulse pattern detector. The FPGA logic may be programmed to analyze the detection pattern of each set of digital pulses, look for temporal correlations between each input (thus each detector) and outputs digital results.

In an embodiment, the analog detector signal may be generated by a pulse detection system, preferably an optical pulse detection system such as a Bell state measurement system, the pulse detection system including one or more photon detectors, each photon detector being coupled to a transformer, e.g. a comparator, to transform an analog detector signal of the photon detector into the analog detector signal, which may comprise one or more detection pulses of a predetermined pulse width at the one or more temporal positions.

In an embodiment, the frequency of the base clock signal may be selected between 50 and 500 MHz, preferably between 100 and 400 MHz.

In a further aspect, the invention relates to a system for determining a detector pattern signal wherein the system comprises: a clock configured to generate a base clock signal; a phase adjustment module comprising one or more logic blocks configured to receiving the base clock signal and to generate a first clock signal based on the base clock signal, the generating including applying a first phase shift to the base clock signal so that the rising edge of first adjusted clock signal is at a first temporal position defined relative to the rising edge of the base clock signal; a pulse generator comprising one or more logic blocks configured to receive at least one analog detection signal generated by a photon detection system at a first clock cycle of the base clock signal, wherein the analog detector signal comprises one or more detector pulses of a predetermined pulse width at one or more temporal positions respectively, each detector pulse representing an optical pulse detected by the optical pulse detection system, the one or more temporal positions being defined relative to the rising edge of the base clock signal; and configured to generate a first pulse signal based on the analog detection signal, the first pulse signal having a pulse width that is smaller than the pulse width of the one or more detection pulses, the first pulse width being selected between 10 and 200 ps, the generating of the first pulse signal including: forming a first delayed detector signal by applying a first delay to the analog detector signal; forming a second delayed detector signal by applying a second delay to the analog detector signal and, determining the first pulse signal based on the first and second delayed detector signal; and, a clock edge sensitive pulse detector comprising one or more logic blocks configured to receive the first pulse signal and the first clock signal and to determine a digital detector pattern signal based on the first pulse signal and the first phase clock signal, the digital detector pattern signal including a first digital signal, the first digital signal indicating whether the analog detector signal comprises a first detection pulse at the first temporal position as indicated by the rising edge of the first clock signal.

In an embodiment, the first pulse signal may be determined by logically combining the analog detector signal and an inverted version of the analog detector signal.

In an embodiment, the rising edge of the first pulse signal may be determined by the rising edge of the analog detection signal and wherein the falling edge of the first pulse signal is determined inverted analog detection signal.

In an embodiment, the first digital signal may be generated by a first logic block configured to receive the first pulse signal and the first clock signal as input and to generate the first digital signal as output, preferably the first logic block including a first D flipflop clocked by the first clock signal.

In an embodiment, the analog detector signal may be generated by a pulse detection system, preferably an optical pulse detection system such as a Bell state measurement system, the pulse detection system including one or more photon detectors, each photon detector being coupled to a transformer, e.g. a comparator, to transform an analog detector signal of the photon detector into the analog detector signal, which may comprise one or more detection pulses of a predetermined pulse width at the one or more temporal positions.

In an embodiment, the width of the first pulse signal may be selected 10 and 200 ps, preferably between 20 and 100 ps; and/or, wherein the frequency of the base clock signal is selected between 50 and 500 MHz, preferably between 100 and 400 MHz.

In a further aspect, the invention may relate to a receiver system, preferably a receiver system for a quantum key distribution system or a quantum communication system, wherein the receiver system comprises as a system for determining a detector pattern signal according to any of the embodiments described above.

The invention may also relate to a computer program product comprising software code portions configured for, when run in the memory of a computer, executing the method steps according to any of process steps described above.

The invention will be further illustrated with reference to the attached drawings, which schematically will show embodiments according to the invention. It will be understood that the invention is not in any way restricted to these specific embodiments.

Brief description of the drawings

    **Fig. 1A** and **1B** illustrate a pulse pattern processing system according to an embodiment of the invention.
    **Fig. 2** illustrates a pulse pattern processing system according to an embodiment of the invention;
    **Fig. 3** depicts an implementation of a pulse pattern processing system according to an embodiment of the invention;
    **Fig. 4** depicts part of a process of detecting pulses using a pulse pattern processing system according to an embodiment of the invention;
    **Fig. 5** depicts part of a process of detecting pulses using a pulse pattern processing system according to an embodiment of the invention;
    **Fig. 6** depicts part of a process of detecting pulses using a pulse pattern processing system according to an embodiment of the invention;
    **Fig. 7** depicts a flow diagram of method of determining a pulse pattern signal according to an embodiment of the invention;
    **Fig. 8** depicts an example of a QKD system comprising a pulse pattern detector according to an embodiment of the invention.

Description of the embodiments

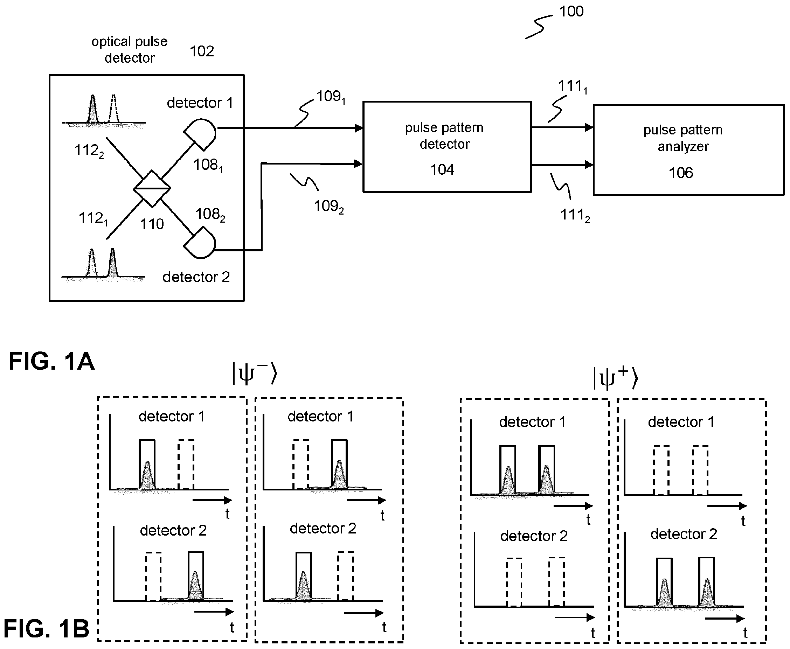

**Fig. 1A** and **1B** illustrate a pulse pattern processing system according to an embodiment of the invention. As shown in **Fig. 1A,** the system may include an optical pulse detection system **102** for detecting optical pulses originating optical encoders. The optical pulse detection system may comprise one or more optical detectors, e.g. photon detectors, which are configured to detect photon pulses. Such photon detector may transform an optical pulse into an electronic pulse. Hence, the outcome of a measurement may be an analog detector signal representing a sequence of analog pulses $109_{1,2}$ forming a certain pulse pattern. A pulse pattern detector **104** may receive an analog pulse signal comprising one or more analog pulses that may be translated into a digital signal that can be readily processed by a pulse pattern analyzer **106.**

The optical pulse detection system may be for example a Bell state measurement (BSM) setup comprising a beam splitter **110** and a first and second photon detector $108_{1,2}$. for detecting time-bin qubits $112_{1,2}$ that may be generated by two different optical qubit generators. An optical time-bin qubit may be regarded as a coherent superposition of two temporal modes of a single-photon excitation. Such optical time-bin qubits may be generated using a Mach Zehnder interferometer or sending a long single photon with a long coherence time through an optical intensity modulator to carve out two different temporal modes. These modes may include a "early" mode $|e\rangle$ and a "late mode" $|l\rangle$ so that a

$$|\Psi\rangle = \left(|e\rangle + e^{i\phi}|l\rangle\right)/\sqrt{2}$$
.

The BSM may be regarded as a projective measurement onto one of the four maximally entangled Bell states $|\Psi^{\pm}\rangle$, $|\Phi^{\pm}\rangle$. The photon detectors of **Fig. 1A** are able to detect photons with sufficient time resolution such that it is possible to distinguish between early and late photons. Thus, depending detection pattern at the output of the detectors different Bell states can distinguished. For example, as shown in **Fig. 1B,** detection of an early and a late pulse detection at one detector relates to a projection on the state $|\Psi^{+}\rangle$. Similarly, one pulse (early or late) at each detector relates to a projection on the state $|\Psi^{-}\rangle$. The illustrate BSM measurement may be executed based on a clock signal, resulting in a BSM result each clock cycle. Executing the measurement at high frequencies, e.g. 200 MHz or more, requires high frequency real-time pulse pattern detection and analysis based on a scheme as depicted in **Fig. 1A.** More generally, many quantum computing schemes require real-time detection and analysis of a set of incoming analogue pulses to find time-sensitive correlations between those pulses. Additionally, the measurement scheme should be scalable in terms of input pulses and is required to be flexible in terms of (re)programming the search for different detection patterns/correlations.

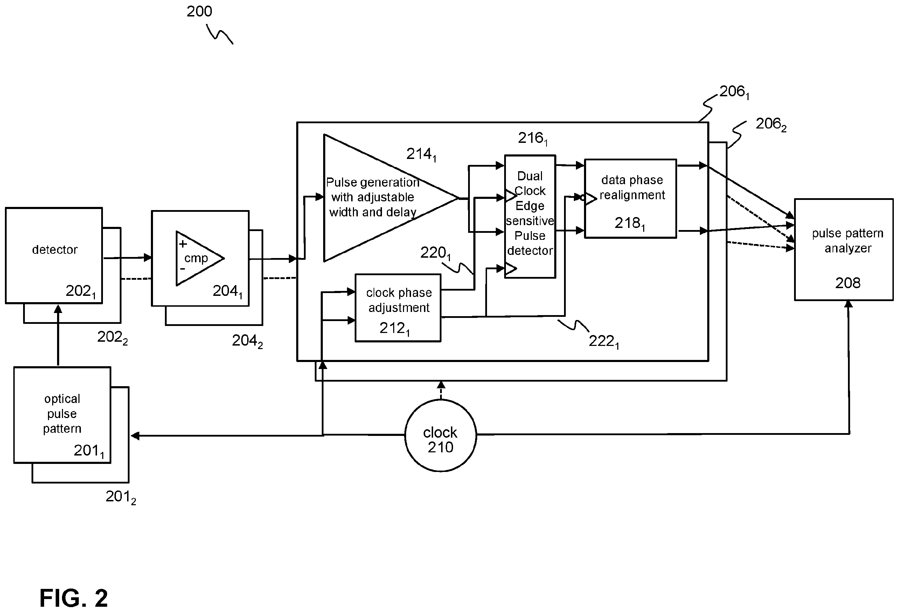

**Fig. 2** illustrates a pulse pattern processing system according to an embodiment of the invention. In particular, this figure depicts a pulse pattern processing system **200** comprising a detection system which may comprise one or more optical detectors $202_{1-n}$ and one or more pulse pattern detectors $206_{1-n}$ configured to detect pulses patterns in analog detector signals generated by the detectors. The detectors $202_{1-n}$ may be configured to generate ultra-fast, non-linear pulses in response to the occurrence of an optical event $201_{1-n}$ such as the arrival of optical pulse signals such as optical time bins. Typically, the detector has a non-linear pulse-shaped response. To make the signal suitable for input to a pulse pattern detector, the non-linear analog detector response may first need to be fed to the input of a first logic bloc $204_{1-n}$ that is configured to transform the non-linear shaped signal into an analog detector signal comprising one or more pulses of a predetermined width and amplitude. In an embodiment, the first logic bloc may include a comparator or an electronic circuit equivalent to a comparator.

Each of the one or more pulse pattern detectors may be configured to detect a pulse pattern in an analog detector signal originating from the detector and to transform information about the detected pattern in a digital output signal. The one or more digital output signals generated by the one or more pulse pattern detectors respectively may be forwarded to a pulse pattern analyzer **208,** e.g. an FPGA-based pulse pattern analyzer which may collectively process the digital outputs of the pulse pattern detectors. The process of generating an optical pulse pattern $201_1$ and the detection of pulse patterns in an analog detector signal by the pulse pattern detector and analysis of the pulse pattern by the pulse pattern analyzer may be synchronized based on a base clock signal of a clock **210** so that the processing of different optical pulse patterns may be executed at high frequencies, e.g. 100 MHz or more.

A pulse pattern detector may include a clock phase adjustment module $212_1.$ To determine a temporal position of a pulse, e.g. a rising edge of a pulse, in an analog detector signal with respect to (a rising edge of) the clock signal, a clock signal may be copied and phase shifted by the clock phase adjustment module into one or more phase shifted clock signals, e.g. a first clock signal $220_1$ and a second clock signal $222_1.$ A rising edge of the clock signal may be phase-shifted to target different temporal bins in the analog detector signal. The pulse pattern detector may further include a pulse generator $214_1,$ which may be configured to receive the analog detector signal that may comprise one or more pulses of a first pulse width and to modify (decrease) the width of the one or more pulses. This way, the pulse generator may generate an analog pulse signal comprising pulses of a second pulse width, which is substantially smaller than the first pulse width. This way, the one or more pulses in the analog pulse signal may be very narrow pulses having a width of around 100 ps or smaller.

The analog pulse signal and the one or more phase shifted clock signals may be fed to the input of an edge-sensitive pulse detector $216_1.$ If the pulse signal comprises a time bin at the temporal position of the rising edge of the phase-shifted clock signal, a digital output signal may be generated by the pulse detector, indicating that a time bin at a certain temporal position relative to the base clock signal has been identified.

Hence, the different phase-shifted clock signals may be used to determine if the analog pulse signal may comprise different pulses at different temporal positions. For each of these temporal positions, a digital output signal may be generated so that the digital output signals together may represent a digital representation of a certain pulse pattern. Due to the phase of the phase-delayed clock signal, a phase difference may be present between the different digital output signals. To remove these phase differences, the pulse pattern detector may further comprise a data phase realignment module $218_1,$ which may be configured to realign the different digital output signals of the pulse detector. Thereafter, the phase-realigned digital output signals may be provided as a digital signal representing a pulse pattern to the pulse pattern analyzer, e.g. an FPGA-based data processing system, which is synchronized based on the clock signal.

Hence, as shown in the figure, invention relates to a pulse pattern processing system and a pulse pattern detector used in such pulse pattern processing system. The pulse pattern detector may be configured to detect a detection pattern signal associated with an analog detector signal that may comprise different pulses. The pulses may represent different time bins in an optical signal that is detected by a detector, e.g. a BSM detector. These pulses need to be detected and the pulse pattern formed by the pulses need to be analyzed, typically in real-time. To that end, a pulse pattern detector may be configured to receive (at least) two inputs: a clock signal and an analog detector signal which may comprise different pulses at certain temporal positions in a clock cycle. Here, the temporal positions in the signal may be determined relative to the start of a clock cycle, e.g. the rising edge of a clock signal.

The invention is scalable as the number of pulse pattern detectors can be stacked while providing input for the FPGA pattern analyzer. The pulse pattern detector may act as a time-filtering system as it only propagates digital pulses if analog pulses occur within one of the temporal windows defined by the clock and d-flipflops. The pulse pattern analyzer may be programmed to search for any particular detection pattern, e.g. pulse counters, time-sensitive coincidence counters, bell-state measurements, large entangled state projective measurements, etc.

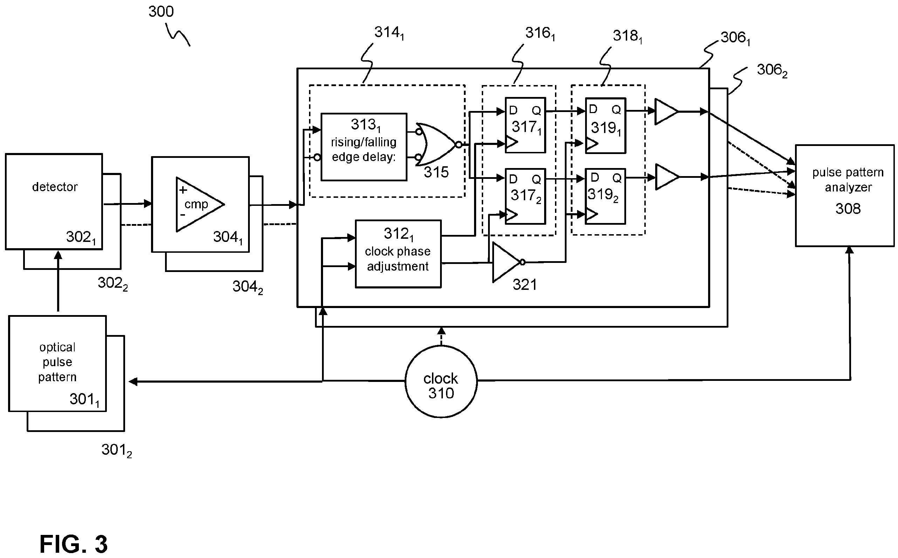

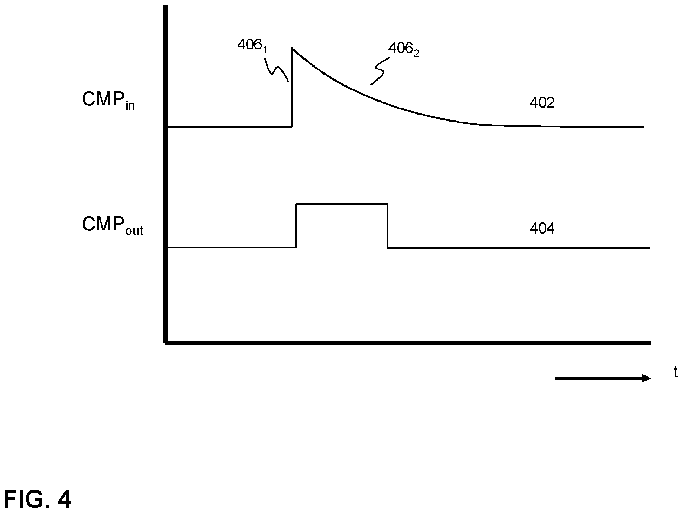

**Fig. 3** depicts an implementation of pulse detecting system according to an embodiment of the invention. In particular, the figure depicts an implementation of a pulse pattern processing system as described with reference to **Fig. 2.** The pulse detecting system may include one or more optical detectors $302_{1-n}$ and one or more pulse pattern detectors $306_{1-n}$ configured to detect pulses patterns in analog detector signals generated by the detectors. an optical pulse pattern $301_1$, a first logic block $304_{1-n}$ that is configured to transform the non-linear shaped signal into an analog detector signal comprising one or more pulses of a predetermined width and amplitude. Similar to the one described with reference to **Fig. 2,** pulse pattern detector $306_1$, may comprise a clock phase adjustment module $312_1$, a pulse generator $314_1$, an edge-sensitive pulse detector $316_1$ and a data phase realignment module $318_1$. Further, the process of generating an optical pulse pattern $301_1$ and the detection of pulse patterns in an analog detector signal by the pulse pattern detector and analysis of the pulse pattern by the pulse pattern analyzer may be synchronized based on a base clock signal of a clock **310.** A pulse pattern detection method executed by the pulse detecting system will be described hereunder in greater detail with reference to the signals illustrated in **Fig. 4-6.**

As shown in **Fig. 3,** a detection cycle may start with the generation of an optical pulse pattern $301_1$, which is detected by a photon detector $302_1$, which in response generates an analog non-linear detector signal. An example of such detector signal **402** is illustrated in **Fig. 4.** Detector capable of generating such detector signals include superconducting nanowire single-photon detectors (SNSPD). The signal may include a very sharp rising edge $406_1$ followed by a decaying flank $406_2$. Each time a photon is absorbed by the SNSPD, a detector response as shown in this figure will be generated. To prepare this highly non-linear signal for input to a pulse pattern detector, the detector signal may be transformed into an analog pulse signal of a predetermined amplitude using a first logic circuit $304_1$ as depicted in **Fig. 3.**

For example, in an embodiment, the detector response may be input to a comparator which may generate a pulse-shaped signal that is suitable for the pulse pattern detector. **Fig. 4** depicts an example of a pulse-shaped signal **404** which has a rising edge that coincides with the rising edge of the detector signal **402.** This signal may be referred to as an analog detector signal. Depending on the photon signal that is detected, the analog detector signal include one or multiple pulses. For example, in case of a BSM measurement, within one clock cycle the analog detector signal may either comprise no, one or two pulses. In case of one pulse, the pulse may either be an early pulse located at a first temporal position in the clock cycle or a late pulse located at a second temporal position.

The analog detector signal may be fed to the input of the pulse generator $314_1$ that is part of the pulse pattern detector $306_1$, which may be configured to modify the pulse width of the one or more pulses in the analog detector signal at the input of the pulse generator. This way, the pulse generator may generate an analog pulse signal comprising one or more pulses of a second pulse width, which is substantially smaller than the first pulse width. To that end, the analog detector signal and an inverted version of the analog detector signal may be provided to the input of a delay circuit $313_1$ which will generate a first delayed detector signal based on a first delay value and an inverted second delayed detector signal based on a second delay value, which are subsequently combined using a logic block, e.g. a NAND logic block **315.**

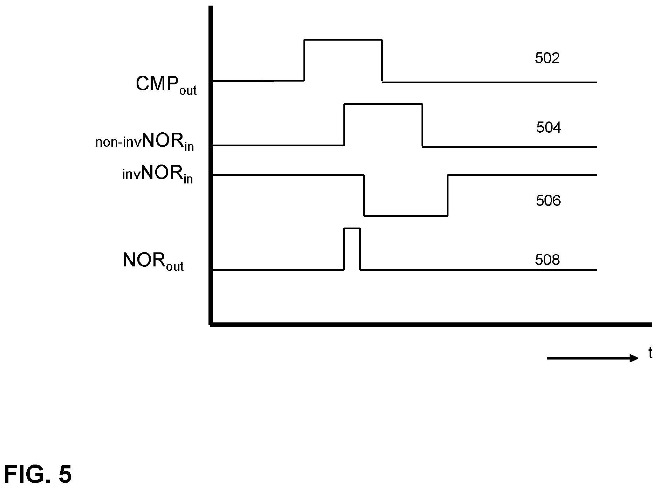

**Fig. 5** depicts this process in terms of signals, including the analog detector signal **502,** the first delayed detector signal **504** and the inverted second delayed detector signal **506.** As shown in the figure, the first and second delay value may be selected such that the rising edge of the first delayed detector signal **504** is positioned before the falling edge of the inverted second detector signal **506** so that a narrow pulse **508** is formed when combining both signals, wherein the pulse width of the narrow pulse is determined by the first and second delay value.

Further, a clock phase adjustment module $312_1$ may receive a base clock signal and produce one or more phase-delayed clock signals, including a first (phase-delayed) clock signal and a second (phase-delayed) clock signal. Then, both the one or more phase-delayed clock signals and the analog pulse signal (the output of the pulse generator $314_1$) which may be fed to the input of the edge-sensitive pulse detector $316_1$, which may include one or more D flipflops $317_{1,2}$, e.g. a first D flipflop and a second D flipflop. Hence, the pulse signal may be fed to the input of the first D flipflop which is clocked based on the first clock signal. Hence, if the analog pulse signal comprises a first time bin at a first temporal position of the rising edge of the first clock signal, the pulse detector will generate a first digital signal indicating that a time bin at the firs temporal position. Similarly, the pulse signal may also be fed to the input of the second D flipflop which is clocked based on the second clock signal, so that if the analog pulse signal comprises a second time bin at a second temporal position of the rising edge of the second clock signal, the pulse detector will generate a second digital signal. This way, the pulse detector will generate a pulse detection pattern representing the detection of a plurality of time bins, e.g. an early and/or a late time bin.

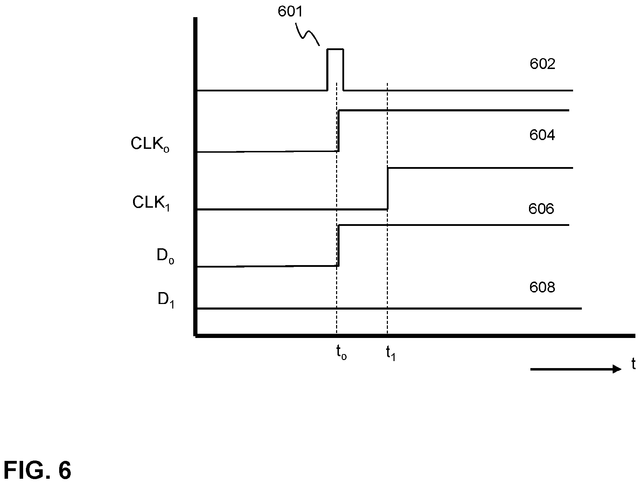

The signals processed by the edge-sensitive pulse detector are illustrated in **Fig. 6.** This figure depicts an analog pulse signal **602** and the first and second clock signals **604,606** with a first rising edge at a first temporal position $t_o$ and a second rising edge at a second temporal position $t_1$. Because the analog pulse signal **602** comprises a first pulse **601** (representing a first time bin) at a first temporal position of the rising edge of the first clock signal, the pulse detector will set the first digital signal Do **606** to a logical high indicating that a time bin at the firs temporal position. Similarly, because the analog pulse signal **602** does not comprise a second pulse (representing a second time bin) at a second temporal position of the rising edge of the second clock signal, the pulse detector will keep the digital signal D1 **606** at a logical low indicating that a time bin at the firs temporal position.

This figure illustrates why a very narrow pulse signal is used for the pulse detector. In particular, it shows that a narrow pulse will reduce the chance that non-correlated signals in the analog pulse signal may influence the determination of the digital signals at the output of the pulse detector. A narrow pulse signal will decrease the chance of errors.

This figure further illustrates that if both the first and second digital signal is set to a logical high, both signals will have a phase difference that is caused by the phase difference between the first and second clock signal. To make the digital signals suitable for input to the FGPA based pulse pattern analyser 308, the signals may be realigned based on a data phase realignment module 3181, which may include two D flipflops $319_{1,2}$ which are clocked based on the second (late) clock signal so that both signals are aligned and can be fed to the input of the pulse pattern analyzer. Thus, a second d-flipflop that is clocked with the same clock signal in both channels, the resulting digital pulses may be easily interfaced with an FPGA-based pattern analysis system that may be clocked based on the same clock signal as the pulse pattern detector. The FPGA logic may be programmed to analyze the detection pattern of each set of digital pulses, look for temporal correlations between each input (thus each detector) and outputs digital results.

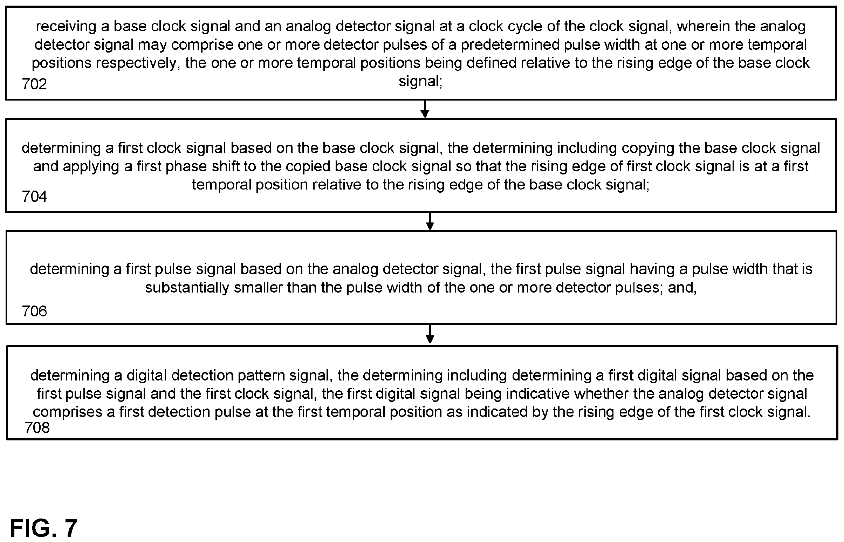

**Fig. 7** depicts a flow diagram of determining a pulse pattern signal according to an embodiment of the invention. As shown in the figure, the method may include a step of receiving a base clock signal and an analog detector signal (step **702**). The reception of new analog detector signals may take place at every clock cycle of the clock signal. The analog detector signal may comprise one or more pulses, i.e. analog pulses, of a predetermined pulse width at one or more temporal positions respectively relative to the start of the clock cycle, e.g. a rising edge of the clock signal. Hence, the one or more temporal positions of the one or more pulses may be being defined relative to the rising edge of the base clock signal.

In a further step **704,** a first clock signal may be determined based on the base clock signal, wherein the determining may include copying the base clock signal and applying a first phase shift to the copied base clock signal so that the rising edge of first clock signal is at a first temporal position relative to the rising edge of the base clock signal. Then, a first pulse signal may be determined based on the analog detector signal, wherein the first pulse signal may have a pulse width that is substantially smaller than the pulse width of the one or more detector pulses (step **706**). Then, a digital pulse pattern signal may be determined. This step may include determining a first digital signal based on the first pulse signal and the first clock signal, wherein the first digital signal may be indicative whether the analog detector signal comprises a first detection pulse at the first temporal position as indicated by the rising edge of the first clock signal (step **708**).

This method may be executed by a pulse pattern detector which effectively functions as analog-to-digital time-filtering system as it only propagates a pattern of digital pulses if analog pulses occur within one of the temporal windows defined by one of the phase-shifted clock signals.

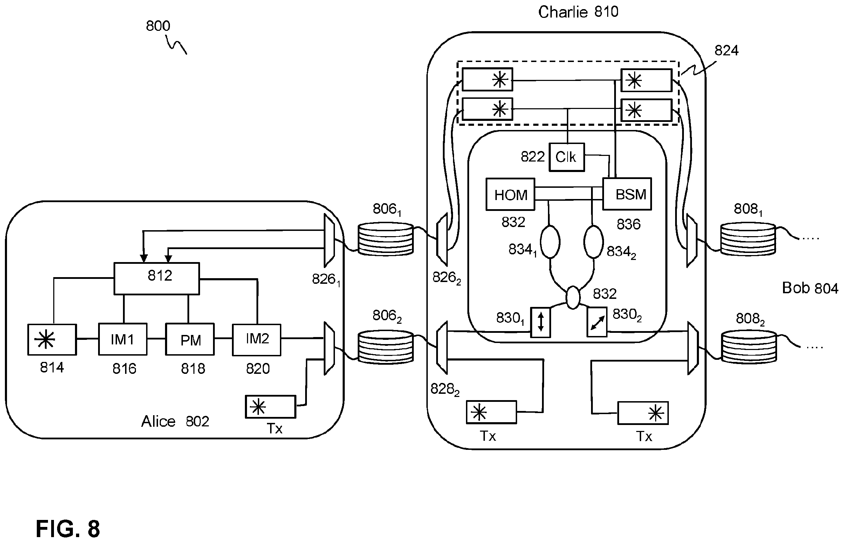

**Fig. 8** depicts an example of a QKD system comprising an optical encoder according to an embodiment of the invention. In particular, the figure illustrates an MDI-QKD design known from the article by Valivarthi et al, A cost-effective measurement-independent quantum key distribution system for quantum networks, Quantum Sic. Technol. 2(2017) that includes one or more optical encoders as described with the embodiments in this application. The system **800** may include a first and second qubit generating modules **802, 804.** Both qubit generating modules may be configured to prepare qubits and send them via optical fibers $806_{1,2}, 808_{1,2}$ to a central measurement station **810,** which may include a so-called Bell state measurement (BSM) module, which may comprise a pulse pattern detector as described with reference to the embodiments in this application.

These optical fibers may be part of a conventional standard optical fiber communication network. Each qubit generating module may include an optical controller **812** for controlling a laser system **814,** such as a continuous wave laser, to generate coherent optical pulses. In an embodiment, optical controller **812** may comprise a pulse generating system as e.g. described with reference to **Fig. 2-5** for generating each clock cycle a pulse signal wherein the pulse signal may either include zero, one or two pulses. The optical pulses generated by the laser system may be processed by first intensity modulator IM1 **816,** which is controlled by the pulse signals of the pulse generating system. In particular, based on the pulse signal, the first intensity modulator may "carve out" time-bin optical modes, early and/or late time bins, to define a photonic qubit. The time-bin optical modes may be processed by a phase modulator PM **818** to control a phase between optical modes. A further second intensity modulator IM2 **820** may be used to control the average number of photons associated with the qubit. This way, both qubit generating modules (Alice and Bob) may generate time-bin qubits in a synchronized way which are transmitted via fiber connections $806_2$, $808_2$ to a central measurement station **810.** For successful performance of the BSM module, the optical modes transmitted by the qubit generating module should be indistinguishable in all degrees of freedom (spatial, spectral, polarization and temporal).

The central measurement station **810,** usually referred to as Charlie, may include a clock distribution system, including a **822** connected to a system of lasers **824** to produce an optical clock signal for the qubit generators. This clock signal may be transmitted via the

optical fibers $806_1$, $808_1$ to the qubit generating modules, which use this high-quality clock signal to both synchronize the qubit generation and to produce a high-quality clock signal for generating the pulses that drive the optical modulator. Further central measurement station may further comprise polarization beam splitters (BS) $830_{1,2}$ and a polarization maintaining beam splitter **832** and superconducting nanowire single-photon detectors (SNSPDs) $834_{1,2}$ to form a BSM measurement setup, wherein the detectors are configured to generate analog detector signals which Bell state measurement (BSM) module, which may comprise pulse pattern detectors configured to detect pulse patterns in the analog detector signals and produce digital signals representation of the detected pulses pattern. The measurement station may further include a so-called Hong-Ou-Mandel dip measurement (HOM) **832** for determining the indistinguishability of the time bins and a BSM analyzer module **836** which is configured to analyze the electrical signals produced by the SNSPDs for the generation of a secret key.

Although the pulse generating systems according to the embodiments in this application are particularly suitable for an MDI-QKD QKQ system, they may also be advantageously used in other QKD systems, optical (quantum) communication systems, quantum signal processing systems as well as a signal generator for generating stimulus and clock signals to analyze and test electrical devices.

The techniques of this disclosure may be implemented in a wide variety of devices or apparatuses, including a wireless handset, an integrated circuit (IC) or a set of ICs (e.g., a chip set). Various components, modules, or units are described in this disclosure to emphasize functional aspects of devices configured to perform the disclosed techniques, but do not necessarily require realization by different hardware units. Rather, as described above, various units may be combined in a codec hardware unit or provided by a collection of interoperative hardware units, including one or more processors as described above, in conjunction with suitable software and/or firmware.

The terminology used herein is for the purpose of describing particular embodiments only and is not intended to be limiting of the invention. As used herein, the singular forms "a," "an," and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

The corresponding structures, materials, acts, and equivalents of all means or step plus function elements in the claims below are intended to include any structure, material, or act for performing the function in combination with other claimed elements as specifically claimed. The description of the present invention has been presented for purposes of illustration and description, but is not intended to be exhaustive or limited to the invention in the form disclosed. Many modifications and variations will be apparent to those of ordinary skill in the art without departing from the scope of the claims. The embodiment was chosen and described in order to best explain the principles of the invention and the practical application, and to enable others of ordinary skill in the art to understand the invention for various embodiments with various modifications as are suited to the particular use contemplated.

## Claims

1. Method of determining a detection pattern signal comprising:

   receiving a base clock signal and an analog detector signal (404) at a clock cycle of a clock signal, the analog detector signal being generated by a photon detection system (202), wherein the analog detector signal comprises one or more detector pulses of a predetermined pulse width at one or more temporal positions respectively, each detector pulse representing an optical pulse detected by the photon detection system (202), the one or more temporal positions being defined relative to the rising edge of the base clock signal;
   generating a first clock signal (604) based on the base clock signal, the generating of the first clock signal including applying a first phase shift to the base clock signal so that the rising edge of first clock signal is at a first temporal position relative to the rising edge of the base clock signal;
   generating a first pulse signal (508) based on the analog detector signal, the first pulse signal having a first pulse width that is smaller than the pulse width of the one or more detector pulses, the first pulse width being selected between 10 and 200 ps; the generating of the first pulse signal including: forming a first delayed detector signal (504) by applying a first delay to the analog detector signal; forming a second delayed detector signal (508) by applying a second delay to the analog detector signal and, determining the first pulse signal based on the first and second delayed detector signal; and,
   generating a digital detector pattern signal, the generating including determining a first digital signal (606) based on the first pulse signal and the first clock signal, the first digital signal indicating whether the analog detector signal comprises a first detection pulse at the first temporal position as indicated by the rising edge of the first clock signal.

2. Method according to claim 1 wherein the first pulse signal is generated by logically combining the analog detector signal and an inverted version of the analog detector signal.

3. Method according to claims 1 or 2 wherein the rising edge of the first pulse signal is determined by the rising edge of the analog detection signal and wherein the falling edge of the first pulse signal is determined by the inverted analog detection signal.

4. Method according to any of claims 1-3, wherein the first digital signal is generated by a first logic block configured to receive the first pulse signal and the first clock signal as input and to generate the first digital signal as output, preferably the first logic block including a first D flipflop clocked by the first clock signal.

5. Method according to any of claims 1-4 further comprising:

generating a second clock signal based on the base clock signal, the determining including applying a second phase shift to the base clock signal so that the rising edge of second adjusted clock signal is at a second temporal position relative to the rising edge of the base clock signal;
generating a second pulse signal based on the analog detector signal, the second pulse signal having a pulse width that is substantially smaller than the pulse width of the one or more detector pulses; and,
generating a digital detector pattern signal, the determining further including: determining a second digital signal based on the second pulse signal and the second clock signal, the second digital signal being indicative whether the analog detection signal comprises a second detection pulse at the second temporal position.

6. Method according to any of claims 1-5, wherein the second digital signal is generated by a second logic block configured to receive the second pulse signal and the second clock signal as input and to generate the second digital signal as output, preferably the second logic block including a second D flipflop clocked by the second clock signal.

7. Method according to any of claims 1-6, wherein the phase of the first digital signal and the phase of the second digital signal are realigned; and/or, wherein the frequency of the base clock signal is selected between 50 and 500 MHz, preferably between 100 and 400 MHz.

8. Method according to any of claims 1-7 wherein the pulse detection system includes one or more photon detectors, each photon detector being coupled to a transformer, e.g. a comparator, to transform an analog detector signal of the photon detector into the analog detector signal, which may comprise one or more detection pulses of a predetermined pulse width at the one or more temporal positions.

9. A system for determining a detector pattern signal comprising:

a clock (210) configured to generate a base clock signal;
a phase adjustment module (212) comprising one or more logic blocks configured to receiving the base clock signal and to generate a first clock signal based on the base clock signal, the generating including applying a first phase shift to the base clock signal so that the rising edge of first adjusted clock signal is at a first temporal position defined relative to the rising edge of the base clock signal;
a pulse generator (214) comprising one or more logic blocks configured to receive at least one analog detection signal generated by a photon detection system (202) at a first clock cycle of the base clock signal, wherein the analog detector signal comprises one or more detector pulses of a predetermined pulse width at one or more temporal positions respectively, each detector pulse representing an optical pulse detected by the optical pulse detection system, the one or more temporal positions being defined relative to the rising edge of the base clock signal; and configured to generate a first pulse signal based on the analog detection signal, the first pulse signal having a pulse width that is smaller than the pulse width of the one or more detection pulses, the first pulse width being selected between 10 and 200 ps, the generating of the first pulse signal including: forming a first delayed detector signal by applying a first delay to the analog detector signal; forming a second delayed detector signal by applying a second delay to the analog detector signal and, determining the first pulse signal based on the first and second delayed detector signal; and,
a clock edge sensitive pulse detector (216) comprising one or more logic blocks configured to receive the first pulse signal and the first clock signal and to determine a digital detector pattern signal based on the first pulse signal and the first phase clock signal, the digital detector pattern signal including a first digital signal, the first digital signal indicating whether the analog detector signal comprises a first detection pulse at the first temporal position as indicated by the rising edge of the first clock signal.

10. System according to claim 9 wherein the first pulse signal is generated by logically combining the analog detector signal and an inverted version of the analog detector signal.

11. System according to claims 9 or 10 wherein the rising edge of the first pulse signal is determined by the rising edge of the analog detection signal and wherein the falling edge of the first pulse signal is determined by the inverted analog detection signal.

12. System according to any of claims 9-12, wherein the first digital signal is generated by a first logic block configured to receive the first pulse signal and the first clock signal as input and to generate the first digital signal as output, preferably the first logic block including a first D flipflop clocked by the first clock signal; and/or, wherein the frequency of the base clock signal is selected between 50 and 500 MHz, preferably between 100 and 400 MHz.

13. System according to any of claims 9-12 wherein the pulse detection system includes one or more photon detectors, each photon detector being coupled to a transformer, e.g. a comparator, to transform an analog detector signal of the photon detector into the analog detector signal, which may comprise one or more detection pulses of a predetermined pulse width at the one or more temporal positions.

14. Receiver system, preferably a receiver system for a quantum key distribution system or a quantum communication system, wherein the receiver system comprises as a system for determining a detector pattern signal according to any of claims 9-13.

15. Computer program product comprising software code portions configured for, when run in the memory of a computer, executing the method steps according to any of claims 1-8.

**Patentansprüche**

1. Verfahren, umfassend:

Empfangen eines Basis-Taktsignals und eines analogen Detektorsignals (404) in einem Taktzyklus eines Taktsignals, wobei das analoge Detektorsignal durch ein Photonendetektionssystem (202) erzeugt wird, wobei das analoge Detektorsignal eine oder mehrere Detektorpulse mit einer vorbestimmten Pulsbreite an einer oder mehreren zeitlichen Positionen umfasst, wobei jeder Detektorpuls einen optischen Puls darstellt, der durch das Photonendetektionssystem (202) detektiert wird, wobei die eine oder mehreren zeitlichen Positionen relativ zur steigenden Flanke des Basis-Taktsignals definiert sind;

Erzeugen eines ersten Taktsignals (604) basierend auf dem Basis-Taktsignal, wobei das Erzeugen des ersten Taktsignals das Anwenden einer ersten Phasenverschiebung auf das Basis-Taktsignal umfasst, sodass die steigende Flanke des ersten Taktsignals an einer ersten zeitlichen Position relativ zur steigenden Flanke des Basis-Taktsignals liegt;

Erzeugen eines ersten Pulssignals (508) basierend auf dem analogen Detektorsignal, wobei das erste Pulssignal eine erste Pulsbreite aufweist, die kleiner ist als die Pulsbreite der einen oder mehreren Detektorpulse, wobei die erste Pulsbreite zwischen 10 und 200 ps ausgewählt ist; wobei das Erzeugen des ersten Pulssignals umfasst:

- Bilden eines ersten verzögerten Detektorsignals (504) durch Anwenden einer ersten Verzögerung auf das analoge Detektorsignal;
- Bilden eines zweiten verzögerten Detektorsignals (508) durch Anwenden einer zweiten Verzögerung auf das analoge Detektorsignal und
- Bestimmen des ersten Pulssignals basierend auf dem ersten und zweiten verzögerten Detektorsignal; und

Erzeugen eines digitalen Detektormustersignals, wobei das Erzeugen umfasst:

- Bestimmen eines ersten Digitalsignals (606) basierend auf dem ersten Pulssignal und dem ersten Taktsignal, wobei das erste Digitalsignal anzeigt, ob das analoge Detektorsignal einen ersten Detektionspuls an der ersten zeitlichen Position gemäß der steigenden Flanke des ersten Taktsignals umfasst.

2. Verfahren nach Anspruch 1, wobei das erste Pulssignal durch logische Kombination des analogen Detektorsignals und einer invertierten Version des analogen Detektorsignals erzeugt wird.

3. Verfahren nach Anspruch 1 oder 2, wobei die steigende Flanke des ersten Pulssignals durch die steigende Flanke des analogen Detektionssignals bestimmt wird und wobei die fallende Flanke des ersten Pulssignals durch das invertierte analoge Detektionssignal bestimmt wird.

**4.** Verfahren nach einem der Ansprüche 1 bis 3, wobei das erste Digitalsignal durch einen ersten Logikblock erzeugt wird, der konfiguriert ist, das erste Pulssignal und das erste Taktsignal als Eingabe zu empfangen und das erste Digitalsignal als Ausgabe zu erzeugen, vorzugsweise wobei der erste Logikblock ein erstes D-Flipflop umfasst, das durch das erste Taktsignal getaktet wird.

**5.** Verfahren nach einem der Ansprüche 1 bis 4, weiter umfassend:

Erzeugen eines zweiten Taktsignals basierend auf dem Basis-Taktsignal, wobei das Bestimmen eine zweite Phasenverschiebung des Basis-Taktsignals umfasst, sodass die steigende Flanke des zweiten angepassten Taktsignals an einer zweiten zeitlichen Position relativ zur steigenden Flanke des Basis-Taktsignals liegt;
Erzeugen eines zweiten Pulssignals basierend auf dem analogen Detektorsignal, wobei das zweite Pulssignal eine Pulsbreite aufweist, die wesentlich kleiner ist als die Pulsbreite der einen oder mehreren Detektorpulse; und
Erzeugen eines digitalen Detektormustersignals, wobei das Bestimmen weiter umfasst:

- Bestimmen eines zweiten Digitalsignals basierend auf dem zweiten Pulssignal und dem zweiten Taktsignal, wobei das zweite Digitalsignal anzeigt, ob das analoge Detektionssignal einen zweiten Detektionspuls an der zweiten zeitlichen Position umfasst.

**6.** Verfahren nach einem der Ansprüche 1 bis 5, wobei das zweite Digitalsignal durch einen zweiten Logikblock erzeugt wird, der konfiguriert ist, das zweite Pulssignal und das zweite Taktsignal als Eingabe zu empfangen und das zweite Digitalsignal als Ausgabe zu erzeugen, vorzugsweise wobei der zweite Logikblock ein zweites D-Flipflop umfasst, das durch das zweite Taktsignal getaktet wird.

**7.** Verfahren nach einem der Ansprüche 1 bis 6, wobei die Phase des ersten Digitalsignals und die Phase des zweiten Digitalsignals neu ausgerichtet werden; und/oder wobei die Frequenz des Basis-Taktsignals zwischen 50 und 500 MHz, vorzugsweise zwischen 100 und 400 MHz, ausgewählt ist.

**8.** Verfahren nach einem der Ansprüche 1 bis 7, wobei das Pulserkennungssystem ein oder mehrere Photonendetektoren umfasst, wobei jeder Photonendetektor mit einem Transformator, z. B. einem Komparator, gekoppelt ist, um ein analoges Detektorsignal des Photonendetektors in das analoge Detektorsignal zu transformieren, das eine oder mehrere Detektionspulse mit einer vorbestimmten Pulsbreite an den einen oder mehreren zeitlichen Positionen umfassen kann.

**9.** System, umfassend:

eine Uhr (210), die konfiguriert ist, ein Basis-Taktsignal zu erzeugen;
ein Phasenanpassungsmodul (212), das einen oder mehrere Logikblöcke umfasst, die konfiguriert sind, das Basis-Taktsignal zu empfangen und ein erstes Taktsignal basierend auf dem Basis-Taktsignal zu erzeugen, wobei das Erzeugen eine erste Phasenverschiebung des Basis-Taktsignals umfasst, sodass die steigende Flanke des ersten angepassten Taktsignals an einer ersten zeitlichen Position relativ zur steigenden Flanke des Basis-Taktsignals definiert ist;
einen Pulsgenerator (214), der einen oder mehrere Logikblöcke umfasst, die konfiguriert sind, mindestens ein analoges Detektionssignal zu empfangen, das durch ein Photonendetektionssystem (202) in einem ersten Taktzyklus des Basis-Taktsignals erzeugt wird, wobei das analoge Detektorsignal eine oder mehrere Detektorpulse mit einer vorbestimmten Pulsbreite an einer oder mehreren zeitlichen Positionen umfasst, wobei jeder Detektorpuls einen optischen Puls darstellt, der durch das optische Pulserkennungssystem detektiert wird, wobei die eine oder mehreren zeitlichen Positionen relativ zur steigenden Flanke des Basis-Taktsignals definiert sind; und konfiguriert ist, ein erstes Pulssignal basierend auf dem analogen Detektionssignal zu erzeugen, wobei das erste Pulssignal eine Pulsbreite aufweist, die kleiner ist als die Pulsbreite der einen oder mehreren Detektionspulse, wobei die erste Pulsbreite zwischen 10 und 200 ps ausgewählt ist, wobei das Erzeugen des ersten Pulssignals umfasst:

- Bilden eines ersten verzögerten Detektorsignals durch Anwenden einer ersten Verzögerung auf das analoge Detektorsignal;
- Bilden eines zweiten verzögerten Detektorsignals durch Anwenden einer zweiten Verzögerung auf das analoge Detektorsignal und
- Bestimmen des ersten Pulssignals basierend auf dem ersten und zweiten verzögerten Detektorsignal; und

einen taktkantensensitiven Pulserkenner (216), der einen oder mehrere Logikblöcke umfasst, die konfiguriert sind, das erste Pulssignal und das erste Taktsignal zu empfangen und ein digitales Detektormustersignal basierend auf dem ersten Pulssignal und dem ersten phasenverschobenen Taktsignal zu bestimmen, wobei das digitale Detektormustersignal ein erstes Digitalsignal umfasst, das anzeigt, ob das analoge Detektorsignal einen ersten Detektionspuls an der ersten zeitlichen Position gemäß der steigenden Flanke des ersten Taktsignals umfasst.

10. System nach Anspruch 9, wobei das erste Pulssignal durch logische Kombination des analogen Detektorsignals und einer invertierten Version des analogen Detektorsignals erzeugt wird.

11. System nach Anspruch 9 oder 10, wobei die steigende Flanke des ersten Pulssignals durch die steigende Flanke des analogen Detektionssignals bestimmt wird und wobei die fallende Flanke des ersten Pulssignals durch das invertierte analoge Detektionssignal bestimmt wird.

12. System nach einem der Ansprüche 9 bis 11, wobei das erste Digitalsignal durch einen ersten Logikblock erzeugt wird, der konfiguriert ist, das erste Pulssignal und das erste Taktsignal als Eingabe zu empfangen und das erste Digitalsignal als Ausgabe zu erzeugen, vorzugsweise wobei der erste Logikblock ein erstes D-Flipflop umfasst, das durch das erste Taktsignal getaktet wird; und/oder, wobei die Frequenz des Basis-Taktsignals zwischen 50 und 500 MHz, vorzugsweise zwischen 100 und 400 MHz, ausgewählt ist.

13. System nach einem der Ansprüche 9 bis 12, wobei das Pulserkennungssystem ein oder mehrere Photonendetektoren umfasst, wobei jeder Photonendetektor mit einem Transformator, z. B. einem Komparator, gekoppelt ist, um ein analoges Detektorsignal des Photonendetektors in das analoge Detektorsignal zu transformieren, das eine oder mehrere Detektionspulse mit einer vorbestimmten Pulsbreite an den einen oder mehreren zeitlichen Positionen umfassen kann.

14. Empfängersystem, vorzugsweise ein Empfängersystem für ein Quanten-Schlüsselverteilungssystem oder ein Quantenkommunikationssystem, wobei das Empfängersystem ein System zur Bestimmung eines Detektormustersignals nach einem der Ansprüche 9 bis 13 umfasst.

15. Computerprogrammprodukt, das Softwarecode-Teile umfasst, die konfiguriert sind, beim Ausführen im Speicher eines Computers die Verfahrensschritte nach einem der Ansprüche 1 bis 8 auszuführen.

**Revendications**

1. Procédé de détermination d'un signal de motif de détection comprenant :

la réception d'un signal d'horloge de base et d'un signal de détecteur analogique (404) à un cycle d'horloge d'un signal d'horloge, le signal de détecteur analogique étant généré par un système de détection de photons (202), dans lequel le signal de détecteur analogique comprend une ou plusieurs impulsions de détecteur d'une largeur d'impulsion prédéterminée au niveau d'une ou plusieurs positions temporelles respectivement, chaque impulsion de détecteur représentant une impulsion optique détectée par le système de détection de photons (202), les une ou plusieurs positions temporelles étant définies par rapport au front montant du signal d'horloge de base ;
la génération d'un premier signal d'horloge (604) sur la base du signal d'horloge de base, la génération du premier signal d'horloge comportant l'application d'un premier déphasage au signal d'horloge de base de sorte que le front montant du premier signal d'horloge se trouve au niveau d'une première position temporelle par rapport au front montant du signal d'horloge de base ;
la génération d'un premier signal d'impulsion (508) sur la base du signal de détecteur analogique, le premier signal d'impulsion ayant une première largeur d'impulsion inférieure à la largeur d'impulsion des une ou plusieurs impulsions de détecteur, la première largeur d'impulsion étant sélectionnée entre 10 et 200 ps ; la génération du premier signal d'impulsion comportant : la formation d'un premier signal de détecteur retardé (504) par application d'un premier retard au signal de détecteur analogique ; la formation d'un deuxième signal de détecteur retardé (508) par application d'un deuxième retard au signal de détecteur analogique et la détermination du premier signal d'impulsion sur la base du premier et du deuxième signal de détecteur retardé ; et,
la génération d'un signal de motif de détecteur numérique, la génération comportant la détermination d'un premier signal numérique (606) sur la base du premier signal d'impulsion et du premier signal d'horloge, le premier signal numérique indiquant si le signal de détecteur analogique comprend une première impulsion de détection au niveau de la première position temporelle telle qu'indiquée par le front montant du premier signal d'horloge.

2. Procédé selon la revendication 1 dans lequel le premier signal d'impulsion est généré par combinaison logique du signal de détecteur analogique et d'une version inversée du signal de détecteur analogique.

3. Procédé selon les revendications 1 ou 2 dans lequel le front montant du premier signal d'impulsion est déterminé par le front montant du signal de détection analogique et dans lequel le front descendant du premier signal d'impulsion est déterminé par le signal de détection analogique inversé.

4. Procédé selon l'une quelconque des revendications 1 à 3, dans lequel le premier signal numérique est généré par un premier bloc logique configuré pour recevoir le premier signal d'impulsion et le premier signal d'horloge en tant qu'entrée et pour générer le premier signal numérique en tant que sortie, de préférence le premier bloc logique comportant une première bascule D cadencée par le premier signal d'horloge.

5. Procédé selon l'une quelconque des revendications 1 à 4 comprenant en outre :

la génération d'un deuxième signal d'horloge sur la base du signal d'horloge de base, la détermination comportant l'application d'un deuxième déphasage au signal d'horloge de base de sorte que le front montant du deuxième signal d'horloge ajusté se trouve au niveau d'une deuxième position temporelle par rapport au front montant du signal d'horloge de base ; la génération d'un deuxième signal d'impulsion sur la base du signal de détecteur analogique, le deuxième signal d'impulsion ayant une largeur d'impulsion qui est sensiblement inférieure à la largeur d'impulsion des une ou plusieurs impulsions de détecteur ; et, la génération d'un signal de motif de détecteur numérique, la détermination comportant en outre : la détermination d'un deuxième signal numérique sur la base du deuxième signal d'impulsion et du deuxième signal d'horloge, le deuxième signal numérique indiquant si le signal de détection analogique comprend ou non une deuxième impulsion de détection au niveau de la deuxième position temporelle.

6. Procédé selon l'une quelconque des revendications 1 à 5, dans lequel le deuxième signal numérique est généré par un deuxième bloc logique configuré pour recevoir le deuxième signal d'impulsion et le deuxième signal d'horloge en tant qu'entrée et pour générer le deuxième signal numérique en tant que sortie, de préférence le deuxième bloc logique comportant une deuxième bascule D cadencée par le deuxième signal d'horloge.

7. Procédé selon l'une quelconque des revendications 1 à 6, dans lequel la phase du premier signal numérique et la phase du deuxième signal numérique sont réalignées ; et/ou, dans lequel la fréquence du signal d'horloge de base est sélectionnée entre 50 et 500 MHz, de préférence entre 100 et 400 MHz.

8. Procédé selon l'une quelconque des revendications 1 à 7 dans lequel le système de détection d'impulsions comporte un ou plusieurs détecteurs de photons, chaque détecteur de photons étant couplé à un transformateur, par exemple un comparateur, pour transformer un signal de détecteur analogique du détecteur de photons en le signal de détecteur analogique, qui peut comprendre une ou plusieurs impulsions de détection d'une largeur d'impulsion prédéterminée au niveau des une ou plusieurs positions temporelles.

9. Système de détermination d'un signal de motif de détecteur comprenant :

une horloge (210) configurée pour générer un signal d'horloge de base ; un module d'ajustement de phase (212) comprenant un ou plusieurs blocs logiques configurés pour recevoir le signal d'horloge de base et pour générer un premier signal d'horloge sur la base du signal d'horloge de base, la génération comportant l'application d'un premier déphasage au signal d'horloge de base de sorte que le front montant du premier signal d'horloge ajusté se trouve au niveau d'une première position temporelle définie par rapport au front montant du signal d'horloge de base ; un générateur d'impulsions (214) comprenant un ou plusieurs blocs logiques configurés pour recevoir au moins un signal de détection analogique généré par un système de détection de photons (202) à un premier cycle d'horloge du signal d'horloge de base, dans lequel le signal de détecteur analogique comprend une ou plusieurs impulsions de détecteur d'une largeur d'impulsion prédéterminée au niveau d'une ou plusieurs positions temporelles respectivement, chaque impulsion de détecteur représentant une impulsion optique détectée par le système de détection d'impulsions optiques, les une ou plusieurs positions temporelles étant définies par rapport au front montant du signal d'horloge de base ; et configurés pour générer un premier signal d'impulsion sur la base du signal de détection analogique, le premier signal d'impulsion ayant une largeur d'impulsion qui est inférieure à la largeur d'impulsion des une ou plusieurs impulsions de détection, la première largeur d'impulsion étant sélectionnée entre 10 et 200 ps, la génération du premier signal d'impulsion comportant : la formation d'un premier signal de détecteur retardé par application d'un premier retard au signal de détecteur analogique ; la formation d'un deuxième signal de détecteur retardé par application d'un deuxième retard au signal de détecteur analogique et la détermination du premier signal d'impulsion sur la base du premier et du deuxième signal de détecteur retardé ; et,

un détecteur d'impulsions sensible au front d'horloge (216) comprenant un ou plusieurs blocs logiques configurés pour recevoir le premier signal d'impulsion et le premier signal d'horloge et pour déterminer un signal de motif de détecteur numérique sur la base du premier signal d'impulsion et du premier signal d'horloge de phase, le signal de motif de détecteur numérique comportant un premier signal numérique, le premier signal numérique indiquant si le signal de détecteur analogique comprend une première impulsion de détection au niveau de la première position temporelle telle qu'indiquée par le front montant du premier signal d'horloge.

10. Système selon la revendication 9 dans lequel le premier signal d'impulsion est généré par combinaison logique du signal de détecteur analogique et d'une version inversée du signal de détecteur analogique.

11. Système selon les revendications 9 ou 10 dans lequel le front montant du premier signal d'impulsion est déterminé par le front montant du signal de détection analogique et dans lequel le front descendant du premier signal d'impulsion est déterminé par le signal de détection analogique inversé.

12. Système selon l'une quelconque des revendications 9 à 12, dans lequel le premier signal numérique est généré par un premier bloc logique configuré pour recevoir le premier signal d'impulsion et le premier signal d'horloge en tant qu'entrée et pour générer le premier signal numérique en tant que sortie, de préférence le premier bloc logique comportant une première bascule D cadencée par le premier signal d'horloge ; et/ou, dans lequel la fréquence du signal d'horloge de base est sélectionnée entre 50 et 500 MHz, de préférence entre 100 et 400 MHz.

13. Système selon l'une quelconque des revendications 9 à 12 dans lequel le système de détection d'impulsions comporte un ou plusieurs détecteurs de photons, chaque détecteur de photons étant couplé à un transformateur, par exemple un comparateur, pour transformer un signal de détecteur analogique du détecteur de photons en le signal de détecteur analogique, qui peut comprendre une ou plusieurs impulsions de détection d'une largeur d'impulsion prédéterminée au niveau des une ou plusieurs positions temporelles.

14. Système récepteur, de préférence un système récepteur pour un système de distribution quantique de clés ou un système de communication quantique, dans lequel le système récepteur constitue un système de détermination d'un signal de motif de détecteur selon l'une quelconque des revendications 9 à 13.

15. Produit de programme informatique comprenant des parties de code logiciel configurées pour, lorsqu'elles sont exécutées dans la mémoire d'un ordinateur, exécuter les étapes de procédé selon l'une quelconque des revendications 1 à 8.

FIG. 1A

FIG. 1B

FIG. 2

FIG. 3

EP 4 268 370 B1

FIG. 4

CMP$_{out}$

$_{non-inv}$NOR$_{in}$

$_{inv}$NOR$_{in}$

NOR$_{out}$

502

504

506

508

t

FIG. 5

FIG. 6

receiving a base clock signal and an analog detector signal at a clock cycle of the clock signal, wherein the analog detector signal may comprise one or more detector pulses of a predetermined pulse width at one or more temporal positions respectively, the one or more temporal positions being defined relative to the rising edge of the base clock signal;

702

determining a first clock signal based on the base clock signal, the determining including copying the base clock signal and applying a first phase shift to the copied base clock signal so that the rising edge of first clock signal is at a first temporal position relative to the rising edge of the base clock signal;

704

determining a first pulse signal based on the analog detector signal, the first pulse signal having a pulse width that is substantially smaller than the pulse width of the one or more detector pulses; and,

706

determining a digital detection pattern signal, the determining including determining a first digital signal based on the first pulse signal and the first clock signal, the first digital signal being indicative whether the analog detector signal comprises a first detection pulse at the first temporal position as indicated by the rising edge of the first clock signal.

708

FIG. 7

FIG. 8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **ARABUL et al.** A precise high count rate FPGA based multi-channel coincidence counting system for quantum photonic applications. *IEEE Photonics Journal*, April 2020, vol. 12 (2)
- **BOSO GIANLUCA et al.** High-throughput gated photon counter with two detection windows programmable down to 70 ps width. *REVIEW OF SCIENTIFIC INSTRUMENTS*, 21 January 2014, vol. 85 (1)
- **VALIVARTHI et al.** A cost-effective measurement-independent quantum key distribution system for quantum networks,. *Quantum Sic. Technol.*, 2017, vol. 2